# EUROPEAN PATENT APPLICATION

(11) **EP 4 553 886 A2**
(43) Date of publication of application: **14.05.2025**
(21) Application number: 25167135.0
(22) Date of filing: 28.03.2025
(51) Int. Cl.: H01J 37/22

(54) **OPTICAL BEAM MEMBER**

(71) Applicant: ASML Netherlands B.V., 5500 AH Veldhoven (NL)
(72) Inventor: DE LEON ARIZPE, Israel, 5500 AH Veldhoven (NL); SAHIN, Ezgi, 5500 AH Veldhoven (NL); VAN T WESTEINDE, Maaike, 5500 AH Veldhoven (NL); LÖW, Peter, 5500 AH Veldhoven (NL); MANGNUS, Albertus, Victor, Gerardus, 5500 AH Veldhoven (NL); BASTIAANS, Koen, Mathijs, 5500 AH Veldhoven (NL); LOOIJE, Alexius, Otto, 5500 AH Veldhoven (NL); BERGLUND, Gun, Sara, Mari, 5500 AH Veldhoven (NL); PINTON, Nadia, 5500 AH Veldhoven (NL)
(74) Representative: ASML Netherlands B.V.

(57) **Abstract**

The present invention provides an optical beam member for a charged particle-optical device configured to direct a charged particle beam towards a sample location. The optical beam member comprises a first beam aperture and one or more optical radiation sources. The first beam aperture is for passage of the charged particle beam. The one or more optical radiation sources are arranged adjacent the first beam aperture. The optical radiation sources are configured to generate and emit optical radiation beams towards the sample location such that an optical beam spot on the sample associated with the one or more optical radiation sources is substantially coincident with a charged particle beam spot on the sample. The charged particle beam spot is associated with the charged particle beam.

## Description

### FIELD

The present invention relates to an optical beam member, an assembly, a charged particle-optical device, a charged particle-optical apparatus and a method for directing optical beams.

### BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

In the context of assessment systems, for example inspection or metrology systems, a photonic element may be used, for example, to direct optical radiation towards the sample. In order to use the photonic element to manipulate optical radiation, optical radiation may be generated using an external optical radiation source and the optical radiation is then coupled into and out of the photonic element. There is a need to provide a more compact and efficient optical component for use in the compact available space in inspection or metrology systems.

### SUMMARY

It is an object of the present disclosure to provide embodiments of an optical member for a charged particle-optical device that, in limited available space, enable an optical radiation beam to illuminate a sample location, and preferably substantially coinciding with a charged particle beam spot on the said sample location.

According to a first aspect of the invention, there is provided an optical beam member for a charged particle-optical device configured to direct a charged particle beam towards a sample location. The optical beam member comprises a first beam aperture and one or more optical radiation sources. The first beam aperture is for passage of the charged particle beam. The one or more optical radiation sources are arranged adjacent the first beam aperture. The optical radiation sources are configured to generate and emit optical radiation beams towards the sample location such that an optical beam spot on the sample associated with the one or more optical radiation sources is substantially coincident with the charged particle beam spot on the sample. The charged particle beam spot is associated with the said charged particle beam directed towards the sample.

According to a further aspect of the invention, there is provided an optical beam member for a charged particle-optical device configured to direct a charged particle beam towards a sample location. The optical beam member comprising a first beam aperture and one or more optical radiation sources. The first beam aperture for passage of the charged particle beam. The one or more optical radiation sources are arranged adjacent the first beam aperture. The optical radiation sources are configured to generate and emit optical radiation beams towards the sample location.

According to a further aspect of the invention, there is provided an assembly for a charged particle-optical device configured to direct one or more charged particle beams towards the sample location. The assembly comprising the optical beam member as described above having one or more first beam apertures and one or more optical radiation sources, and an aperture element. One or more second beam apertures are defined in the aperture element for passage of the respective one or more charged particle beams towards the sample location. The optical beam member is between the aperture element and the sample location.

According to a further aspect of the invention, there is provided an assembly for a charged particle-optical device configured to direct one or more charged particle beams towards the sample location. The assembly comprises an optical beam member as described above having one or more first beam apertures and one or more optical radiation sources and an aperture element. The aperture element is disposed between the optical beam member and the sample location. A one or more second beam apertures are defined in the aperture element for passage of the respective one or more charged particle beams towards the sample location.

According to a further aspect of the invention, there is provided a charged particle-optical device configured to direct one or more charged particle beams towards a sample location. The charged particle-optical device comprising the assembly as described above.

According to a further aspect of the invention, there is provided a method for directing optical beams towards a sample. The method comprising generating and emitting, from one or more optical radiation sources of an optical beam member for a charged particle-optical device configured to direct a charged particle beam towards a sample, respective optical beams towards the sample such that an optical beam spot on the sample associated with the one or more optical radiation sources is substantially coincident with the charged particle beam spot on the sample. A first beam aperture is defined in an optical beam member for passage of the charged particle beam towards the sample. The one or more optical radiation sources are arranged adjacent the first beam aperture. The charged particle beam spot being associated with the charged particle beam.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts an alternative multi-beam charged particle-optical device, for example of the assessment apparatus of Figure 1;
- Figure 5 schematically depicts a charged particle-optical device array;
- Figure 6 schematically depicts a detector array in plan view;
- Figure 7 schematically depicts a detector array and objective lens in cross-section, with an optical beam member on a downbeam side of the detector array;
- Figure 8 schematically depicts a detector array and objective lens in cross-section, with an optical beam member between the objective lens and the detector array;
- Figure 9A and 9B schematically depicts an arrangement in accordance with Figure 7, wherein the optical beam member comprises optical radiation sources having optical radiation manipulating structures comprising micro-lensing structures;
- Figure 10A and 10B schematically depicts an arrangement in accordance with Figure 7, wherein the optical beam member comprises optical radiation sources having optical radiation manipulating structures comprising diffractive structures;
- Figure 11A and 11B schematically depicts an arrangement in accordance with Figure 7, wherein the optical beam member comprises optical radiation sources having optical radiation manipulating structures comprising metalens structures;
- Figure 12A to 12C schematically depicts an optical radiation manipulating structure comprising optical beam-shaping structures, and an arrangement in accordance with Figure 7, wherein the optical beam member comprises optical radiation sources having optical radiation manipulating structures comprising optical beam-shaping structures;
- Figure 13A and 13B schematically depicts an arrangement in accordance with Figure 7, wherein the optical beam member comprises optical radiation sources each disposed on a respective detector element of the detector array;
- Figure 14A and 14B schematically depicts an arrangement in accordance with Figure 7, wherein the optical beam member comprises optical radiation sources each disposed between a substrate and a transparent material layer of a respective detector element of the detector;
- Figure 15A and 15B schematically depicts an arrangement in accordance with Figure 8, wherein the optical beam member comprises optical radiation sources having optical radiation manipulating structures comprising micro-lensing structures; and
- Figure 16A to 16D schematically depicts an arrangement in accordance with Figure 8, wherein the optical beam member comprises optical radiation sources having an annular ring shape.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7.7%. It is desirable to determine defects quickly so as to maintain a high substrate throughput, defined as the number of substrates processed per hour.

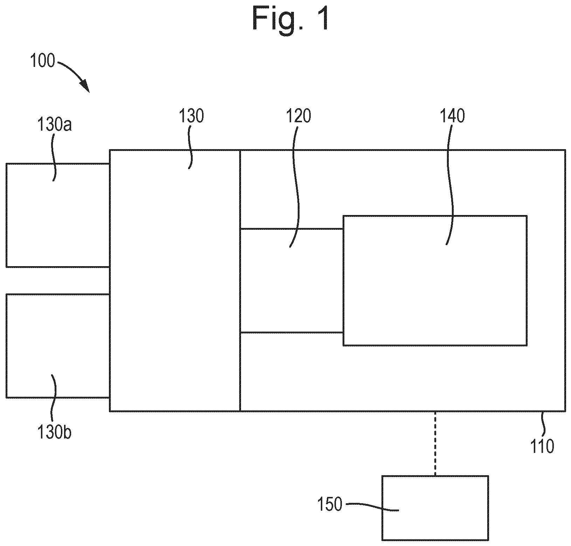

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

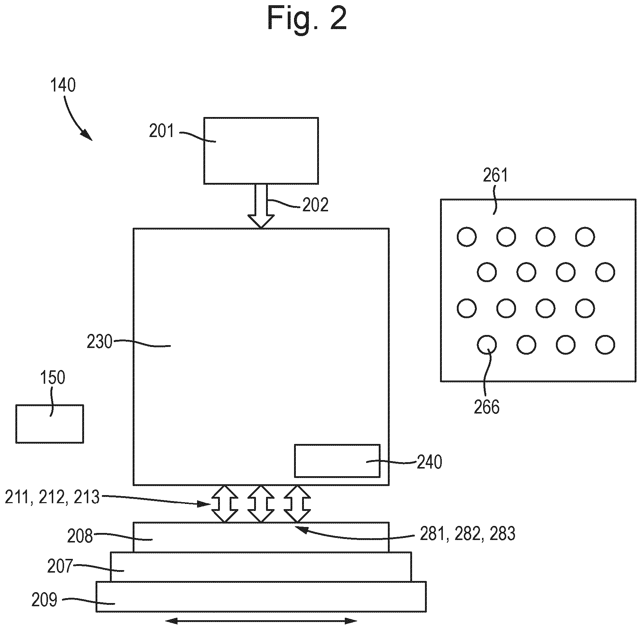

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to as an array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

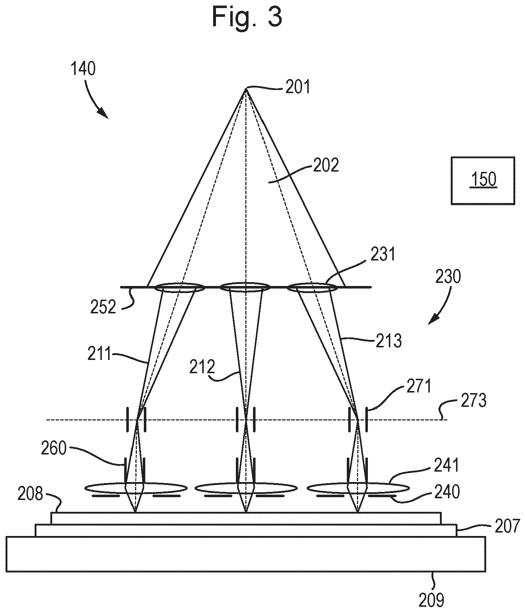

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

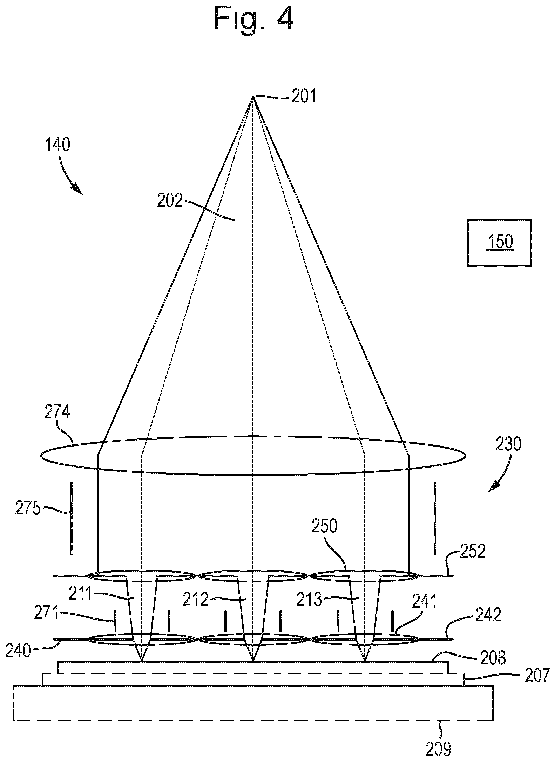

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

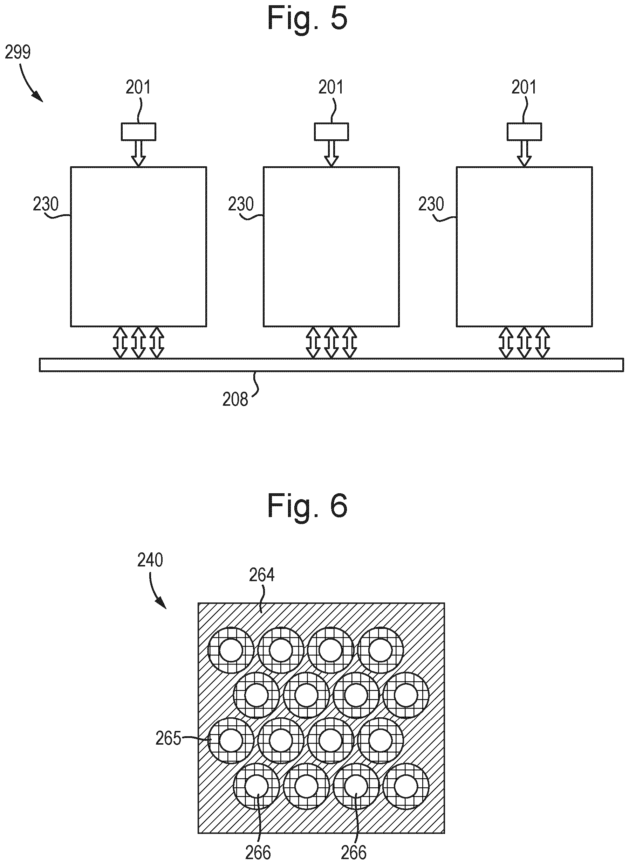

Figure 5 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

Figure 6 is a bottom view of the detector array 240 which comprises a detector substrate 264 on which are provided a plurality of detector elements 265 each surrounding a beam aperture 266. The detector array 240 may be provided at a downbeam surface of a plate 261 comprising beam apertures 266. In an embodiment, the detector elements 265 are charge capture electrodes, for example metal plates. The beam apertures 266 may be formed by etching through the detector substrate 264. In the arrangement shown in Figure 6, the beam apertures 266 are in a hexagonal close packed array. The beam apertures 266 can also be differently arranged, e.g. in a rectangular array.

Photonic elements may be used manipulate optical radiation. In particular, a photonic element may be employed to manipulate the optical radiation and direct optical radiation to other components and/or modules in a system where the manipulated light is further to be utilized. In the context of the charged particle-optical device 230, for example as described above in reference to any of Figures 1 to 6, a photonic element may be used to direct optical radiation towards the sample 208 or sample location. For example, where the charged particle-optical device 230 is an electron-optical device, one or more electron beams scan the sample 208. A photonic element integrated into the charged particle-optical device may be configured to receive optical radiation from an external optical radiation source and to illuminate the sample 208 with the optical radiation in order to improve defect contrast during defect inspection. This technique, which may be referred to as voltage contrast, may be used to measure whether there is a proper electrical connection between a contact and the substrate of the sample 208. The photonic element may be configured to manipulate optical radiation on a planar circuit. The planar circuit may be an integrated optical circuit, such as a photonic integrated circuit. In order to use the photonic element to manipulate optical radiation, optical radiation may be generated using an external optical radiation source and the optical radiation is then coupled into and out of the photonic element. Means of coupling optical radiation into and/or out of a photonic element may include grating couplers, edge couplers, cleaved waveguides, evanescent light couplers, and a combination of these structures with micro-optics components. Often, the coupling means that is selected is specific to the intended use case and is not readily adaptable to different use cases. Integration of a photonic element into the charged particle-optical device 230, as described above, can pose a challenge to the coupling of optical radiation from the external radiation source to the photonic element. Given the different components in the charged particle-optical device 230, for example as shown in Figs. 1-6, the photonic element may need to be integrated within a very compact space - for example, within a spacing in the order of 10µm-200µm with respect to adjacent components of the charged particle-optical device 230. Furthermore, there may be limitations on the maximum power that can be outcoupled via components such as grating couplers. As a result, there is a desire to provide a simpler and more efficient means to provide sufficient optical radiation to illuminate the sample 208, that is sufficiently compact to readily and adaptably fit in the compact space available in the charged particle-optical device 230.

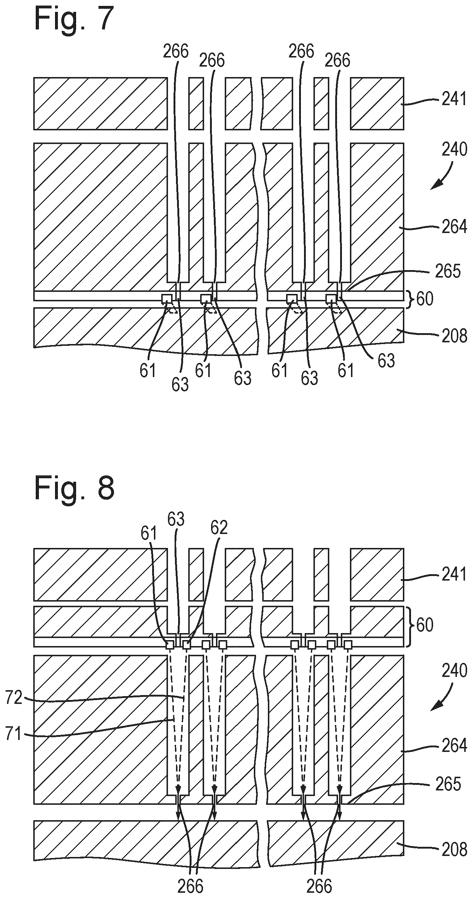

Figures 7-16 show arrangements related to an optical beam member 60 for a charged particle-optical device 230, such as described above in reference to Figures 1-6. The charged particle-optical device 230 is configured to direct one or more charged particle beams 211, 212, 213 towards a sample location, on a surface of the sample 208. The optical beam member 60, for example as shown in Figures 7 and 8, comprises a first beam aperture 63 and one or more optical radiation sources 61, 62. The optical beam member 60 may comprise a substrate in which the first beam aperture 63 is defined. The first beam aperture 63 is configured for passage of the charged particle beam 211, 212, 213. In other words, the first beam aperture 63 enables one or more charged particle beams 211, 212, 213 to pass through the optical beam member 60 towards the sample location on the surface of the sample 208 in order to form a respective one or more charged particle beam spots on the sample 208 at respective sample locations. The optical radiation sources 61, 62 are configured to generate and emit optical radiation beams 71, 72 towards the sample location such that an optical beam spot on the sample 208 associated with the one or more optical radiation sources 61, 62 is substantially coincident with a charged particle beam spot on the sample 208. The one or more optical radiation sources 61, 62 are arranged adjacent the first beam aperture 63. In particular, the one or more optical radiation sources 61, 62 are configured to be positioned proximal to the first beam aperture 63 such that the optical beam spot and the charged particle beam spot are readily at least partially, and optionally fully, overlapping at the sample location on the sample 208. In this way, the compact optical beam member 60 may be used to provide illumination of the sample location, for example for voltage contrast. Furthermore, the optical radiation sources 61, 62 are within the optical beam member 60 which may be provided in the charged particle-optical device 230, rather than the optical radiation being directed to the sample location from an external radiation source located outside the charged particle-optical device 230. The more direct provision of optical radiation is advantageously more simple and reduces loss of optical radiation intensity due to distance and complexity of transmission (e.g., through a series of optical fibers, couplers and gratings).

In a preferred arrangement, the optical radiation sources 61, 62 be configured to be integrated optical radiation sources. The integrated optical radiation sources 61, 62 are integrated in the substrate of the optical beam member 60. The optical beam member 60 may be considered to be a photonic element, such as a photonic integrated circuit (PIC). In other words, the optical beam member 60 may be configured to support and provide power to the optical radiation sources 61, 62.

The one or more optical radiation sources 61, 62 are desirably configured to generate and emit optical radiation in the form of light, preferably in the visible range. The optical radiation may have a wavelength from 200 nm to 1000 nm, preferably from 300 nm to 900 nm, more preferably from 400 nm to 800 nm.

In order to aid in fitting into a compact space, the one or more optical radiation sources 61, 62 are preferably micro-optical radiation sources. The micro-optical radiation sources each optionally have a height and/or width of from 0.5 µm to 100 µm, preferably 1 µm to 50 µm, more preferably 10 µm to 40 µm, yet more preferably 20 µm to 30 µm.

The one or more optical radiation sources may be selected from a group comprising: a light emitting diode (LED), micro-LED, a vertical-cavity surface-emitting laser (VCSEL) and/or a photonic crystal surface-emitting laser (PCSEL).

The power provided to each of the optical radiation sources 61, 62 is desirably approximately equal. For example, the power provided to each of the optical radiation sources 61, 62 may be within 30 % of a threshold power level, preferably within 20 %, more preferably 10%, yet more preferably 5% of a threshold power level. The threshold power level may be the desired, or target, power to be applied to each optical radiation source 61, 62.

The optical beam member 60 is preferably configured for a charged particle-optical device 230 configured to direct a plurality of charged particle beams 211, 212, 213 along respective charged particle-optical axes towards the sample location. In an arrangement such as this, for example as shown in Figures 7 and 8, the optical beam member 60 comprises a plurality of the first beam apertures 63 for passage of respective charged particle beams 211, 212, 213 towards the sample location. The optical radiation sources 61, 62 comprise one or more optical radiation sources 61, 62 adjacent each first beam aperture 63. For example, there may be one optical radiation source 61 adjacent each beam aperture 63, as in the arrangement shown in Figure 7. Alternatively, there may be two (or optionally more than two) optical radiation sources 61, 62 adjacent each beam aperture 63, as in the arrangement shown in Figure 8.

The optical radiation sources 61, 62 are configured to generate and emit optical radiation beams 71, 72 (alternatively referred to as optical beams) towards the sample location such that an optical beam spot on the sample 208 associated with the one or more optical radiation sources 61, 62 is substantially coincident with a respective charged particle beam spot on the sample 208. The respective charged particle beam spot may be associated with a charged particle beam 211, 213, 213 which has passed through the respective first beam aperture 63 to which the optical radiation sources 61, 62 are adjacent.

The plurality of first beam apertures 63 may optionally comprise one or more subsets of the first beam apertures 63. Each subset of the first beam apertures 63 comprises one or more first beam apertures 63. The optical radiation sources 61, 62 may comprise one or more optical radiation sources 61, 62 adjacent each beam aperture 63 of the subset of the first beam apertures. The optical radiation sources 61, 62 are configured to generate and emit optical radiation beams towards the sample location such that an optical beam spot on the sample associated with the one or more optical radiation sources 61, 62 is substantially coincident with a respective charged particle beam spot on the sample 208.

In some arrangements, the charged particle-optical device 230 comprises an objective lens 241 configured to focus the one or more charged particle beams 211, 212, 213 onto the sample location. In preferred arrangements, such as shown in Figures 7 and 8, the optical beam member 60 is between the objective lens 241 and the sample 208. By locating the optical beam member 60 between the objective lens 241 and the sample 208, the optical beam member 60 may be located closer to the sample 208. The optical beam member 60 may be located downbeam of the objective lens array 241 and upbeam of the detector array 240, for example as shown in Figures 8, 15A and 16A. Alternatively, the optical beam member 60 may be located at or downbeam of the detector array 240 and upbeam of the sample 208, for example as shown in Figures 7, 9A, 10A, 11A, 13A, and 14A. By locating the optical beam member 60 close to the sample 208, the intensity of the optical beam 71 on the sample 208 may be improved. However, it is not essential for the optical beam member 60 to be downbeam of the objective lens array 241. In an alternative arrangement, the optical beam member 60 may be placed further upbeam within the electron-optical device 230.

In some arrangements the optical beam element 60 may be considered as a component of an assembly for a charged particle-optical device 230. In particular, the assembly may comprise the optical beam member 60 and at least one aperture element. One or more second beam apertures are defined in the aperture element. The second beam apertures enable passage of respective charged particle beams 211, 212, 213 of the charged particle-optical device 230 towards the sample location. For example, the aperture element may comprise a substrate and the second beam apertures may be defined by the substrate.

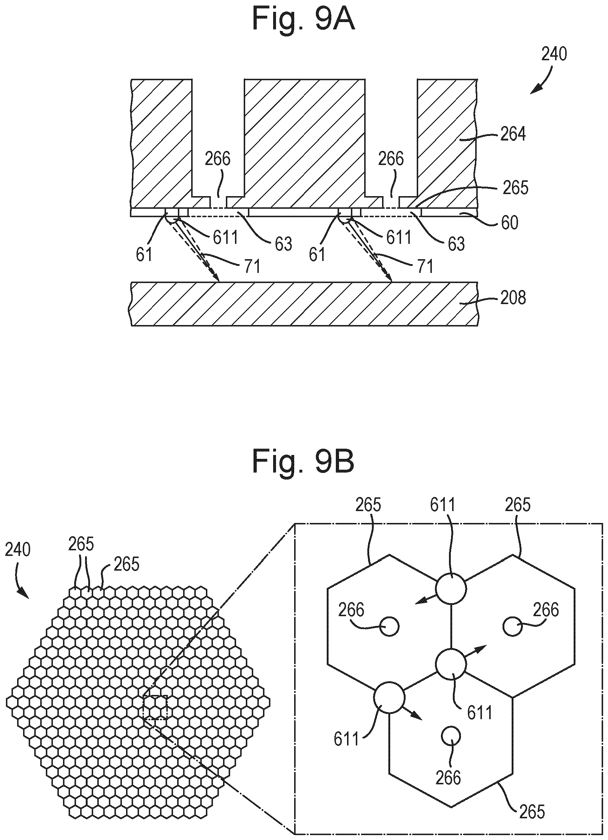

As shown, for example, in Figure 7 (as well as Figures 9A, 10A, 11A, 13A and 14A), in some arrangements the optical beam member 60 is between the aperture element and the sample location. The aperture element may consist of or comprise a detector, for example in the form of a detector array 240 (such as described above in reference to Figures 2 to 6). The detector faces the sample location and is configured to detect emitted charged particles from the sample location in response to the charged particle beam spot on the sample location. The second beam apertures 266 are defined in the detector 240. In particular, the second beam apertures 266 may be defined in a detector substrate 264 of the detector 240.

Preferably, the detector array 240 comprises a plurality of detector elements 265. Each detector element 265 surrounds one of the second beam apertures 266, for example as shown and described above with respect to Figure 6. Preferably, in a plane of the detector 240 (as shown in Figure 6), a lateral dimension of the second beam aperture 266 is less than half a lateral dimension of the detector element 265. In other words, a diameter of the second beam aperture 266 is less than half a width of the corresponding detector element 265. In this way, a size of the detector element 265 may be appropriate for detection of charged particles resulting from the charged partible beam 211, 212, 213 which passes through the corresponding second beam aperture 266 and is incident on the sample 208 at the sample location.

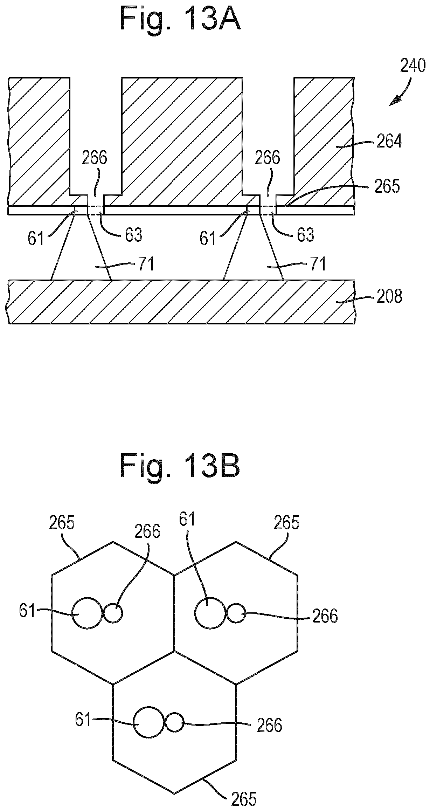

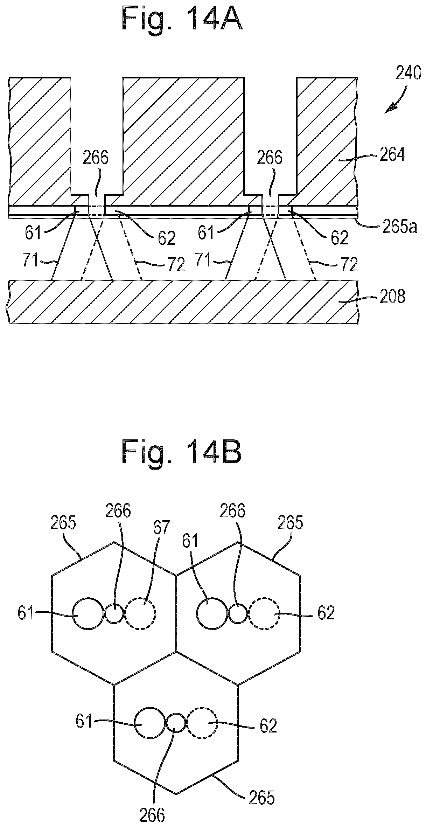

In the arrangement shown in Figure 7 (as well as in the arrangements of Figures 9 to 14), the optical beam member 60 is integrated with, or disposed directly in contact with, the detector 240. These arrangements have the advantage that the optical beam member 60 is at a downbeam position closer to the sample 208, which may aid in readily illuminating the sample location with optical radiation. In some arrangements, the one or more optical radiation sources 61, 62 may be disposed on or integrated within the corresponding detector element 265 (for example as shown and described with respect to Figures 13 and 14). In an alternative arrangement, the optical beam member may be disposed downbeam (in a direction towards the sample 208) of the detector 240 and optionally may not contact the detector 240.

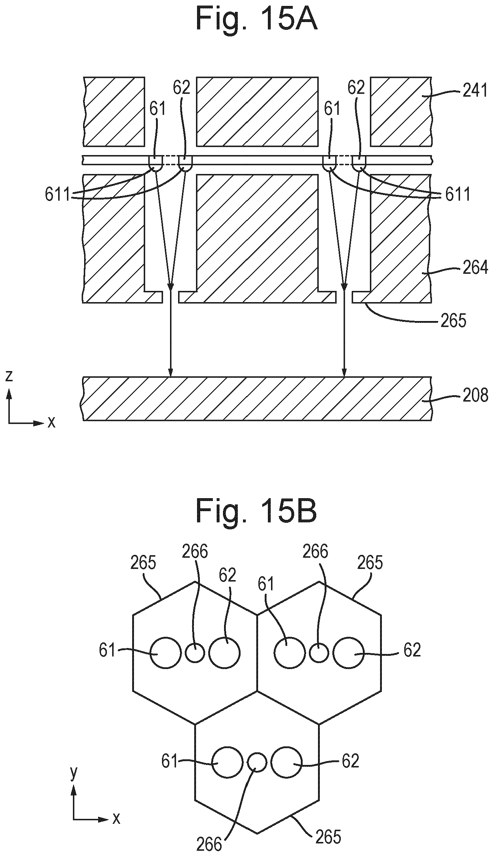

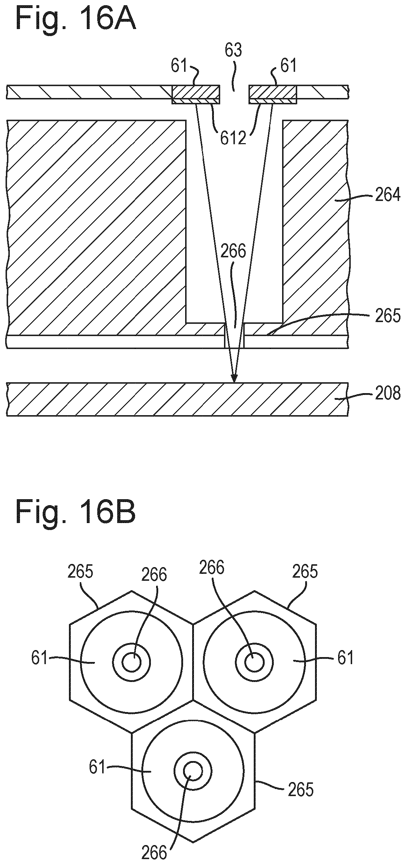

As shown, for example, in Figure 8 (as well as Figures 15A and 16A), in some arrangements the aperture element is disposed between the optical beam member 60 and the sample location. These arrangements have the advantage that the optical beam member 60 may be more adaptable and may be provided at whatever position is considered convenient and has available space, without requiring modification of the detector 240. In this arrangement, it is preferable that, for each second beam aperture 266, the optical beam member 60 is further configured to emit the respective optical beams 71,72 from the optical radiation sources 61, 62, to pass through the respective second beam apertures 266 towards the sample location. In other words, in order to reach the sample 208, the optical radiation generated by the optical radiation sources 61, 62 passes through respective second beam apertures 266 in the aperture element which is downbeam of the optical beam element 60.

In some arrangements, as shown in Figures 8 and 15A, a plurality of optical radiation sources is provided with one or more optical radiation sources 61, 62 associated with each second beam aperture 266. The plurality of optical radiation sources 61, 62 is configured to emit a respective plurality of optical beams to pass through the respective second beam aperture 266. The plurality of optical radiation sources may optionally be configured such that the respective plurality of optical radiation beams are coherent with each other. The plurality of optical radiation sources 61, 62 corresponding to or associated with the respective second beam aperture 266 may be configured such that the plurality of optical radiation beams overlap resulting in constructive interference. In this way, the sample location may be more effectively illuminated. Alternatively, or additionally, in some arrangements, the plurality of optical radiation sources 61, 62 associated with each second beam aperture 266 are configured to generate and emit the respective optical radiation beams, substantially at or near the respective second beam aperture 266. The plurality of optical radiation sources 61, 62 is preferably configured to emit a respective plurality of optical radiation beams to pass through the respective second beam aperture 266 such that the plurality of optical radiation beams overlap at the sample location. In this way, the sample location may be more effectively illuminated.

As described above with respect to Figure 7, in the arrangement of Figures 8, 15 and 16, the aperture element may be a detector (for example a detector array 240).

Preferably (for example, as shown in Figures 9 to 12, 15 and 16), the one or more optical radiation sources 61, 62 each comprises an optical radiation manipulating structure 611, 612, 613, 614 configured to direct and/or focus the optical radiation towards the sample location. In this way, the optical radiation from the one or more optical radiation sources 61, 62, corresponding to each first beam aperture 63, can be more efficiently directed to the sample location, and to therefore be coincident with the respective charged particle beam spot on the sample 208.

Figure 9A depicts a cross-sectional view through an optical beam element 60 comprising optical radiation sources 61 configured to generate and emit optical radiation towards the sample location. The arrangement of Figure 9A is similar to that of Figure 7, wherein the optical beam element 60 is disposed in contact with a downbeam side of the detector substrate 264. In the arrangement of Figure 9A, it is depicted that there is one optical radiation source 61 corresponding to each first beam aperture 63. However, in alternative arrangements, there may be more than one optical radiation source 61, 62 corresponding to each first beam aperture 63. The difference between the arrangement of Figure 7 and that of Figure 9A is that, in the arrangement of Figure 9A, the optical radiation sources 61 are each provided with an optical radiation manipulating structure. The optical radiation manipulating structure in the arrangement of Figure 9A comprises a micro-lensing structure 611. A micro-lensing structure 611 such as this may be configured to direct and/or focus the optical radiation, generated and emitted by the respective optical radiation source 61, towards the sample location. This arrangement has the advantage that the optical radiation may be used efficiently, where needed, by appropriately configured directing and focusing the optical radiation beams 71.

Figure 9B shows a view of a downbeam side of the detector array 240 of the arrangement of Figure 9A. The detector array 240 of Figure 9B comprises the plurality of detector elements 265. In Figure 9A, the detector elements 265 are arranged in a grid, in particular a hexagonal tessellated array pattern, however, in other arrangements, the detector elements 265 may have a different alternative shape and/or a different array pattern. Figure 9B also shows a close up (i.e., zoomed in) view of some example detector elements 265, which additionally shows the position of the corresponding second beam apertures 266 and the corresponding optical radiation sources 61 with the micro-lensing structure 611 provided thereon. Arrows are used in Figure 9B to show the direction in which each micro-lensing structure 611 directs the optical radiation generated by the corresponding optical radiation source 61.

As shown in Figures 9A and 9B, each micro-lensing structure 611 is configured to direct and focus the optical radiation beam 71, generated and emitted by the respective optical radiation source 61, towards the sample location. In particular, the micro-lensing structures 611 are preferably configured to direct and focus the beam over the regions of interest, at the sample location corresponding to the respective charged particle beam spot. This may be achieved through any suitable micro-optics, and is not limited to the use of a traditional lens. For example, free-form micro-optics can be fabricated using additive manufacturing techniques to create the focal spot at the correct working distance while also affecting the direction of the optical radiation beam 71. Alternatively, or additionally, the micro-lensing structure 611 may comprise a focusing diffractive structure.

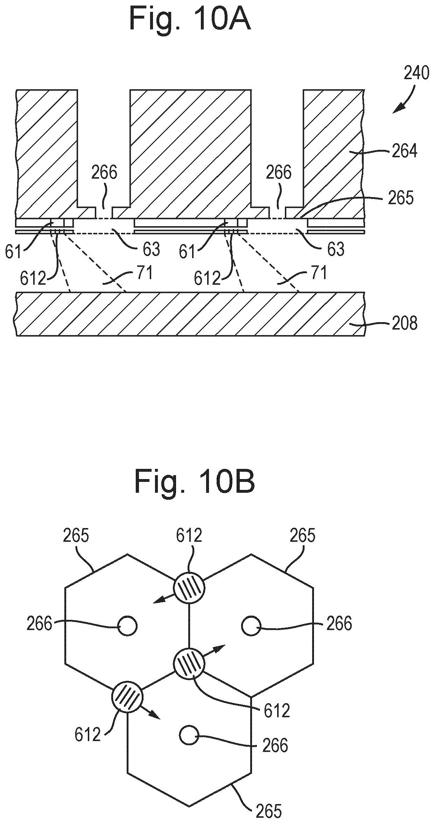

Figure 10A depicts a cross-sectional view through an optical beam element 60 comprising optical radiation sources 61 configured to generate and emit optical radiation towards the sample location. The arrangement of Figure 10A is similar to that of Figure 7, wherein the optical beam element 60 is disposed in contact with a downbeam side of the detector substrate 264. In the arrangement of Figure 10A, it is depicted that there is one optical radiation source 61 corresponding to each first beam aperture 63. However, in alternative arrangements, there may be more than one optical radiation source 61, 62 corresponding to each first beam aperture 63. The difference between the arrangement of Figure 7 and that of Figure 10A is that, in the arrangement of Figure 10A the optical radiation sources 61 are each provided with an optical radiation manipulating structure. The optical manipulating structure in the arrangement of Figure 10A comprises a diffractive structure 612. A diffractive structure 612 such as this may be configured to direct the optical radiation, generated and emitted by a respective optical radiation source 61, towards the sample location. This arrangement has the advantage that the optical radiation may be used efficiently, where needed, by appropriately configured directing the optical radiation beams 71.

Figure 10B shows a close up (i.e., zoomed in) view of some example detector elements 265 on the downbeam side of the detector array 240. Figure 10B also shows the position of the corresponding second beam apertures 266 and the corresponding optical radiation sources 61 with the diffractive structure 612 provided thereon. Arrows are used in Figure 10B to show the direction in which each diffractive structure 612 directs the optical radiation generated by the corresponding optical radiation source 61.

As shown in Figures 10A and 10B, each diffractive structure 612 is configured to direct the optical radiation beam 71, generated and emitted by the respective optical radiation source 61, towards the sample location. In particular, the diffractive structures 612 are preferably configured to direct and focus the beam over the regions of interest, at the sample location corresponding to the respective charged particle beam spot. For example, the optical radiation beam 71 may be directed such that an optical beam spot on the sample coincides with a charged particle beam axis which passes through the corresponding second beam aperture 266, and first beam aperture 63. This may be achieved through any suitable diffractive structure. For example, the diffractive elements may be configured to operate on optical radiation in one or more particular wavelength ranges. If there are a plurality of wavelength ranges of interest, the diffractive structure 612 may comprise a multilayer diffractive grating structure, wherein each of the layers comprises a grating configured for a particular target wavelength range. The diffractive structure 612 is optionally formed on an optical manipulating layer of the optical beam element 60, which is downbeam of a layer housing the optical radiation source 61.

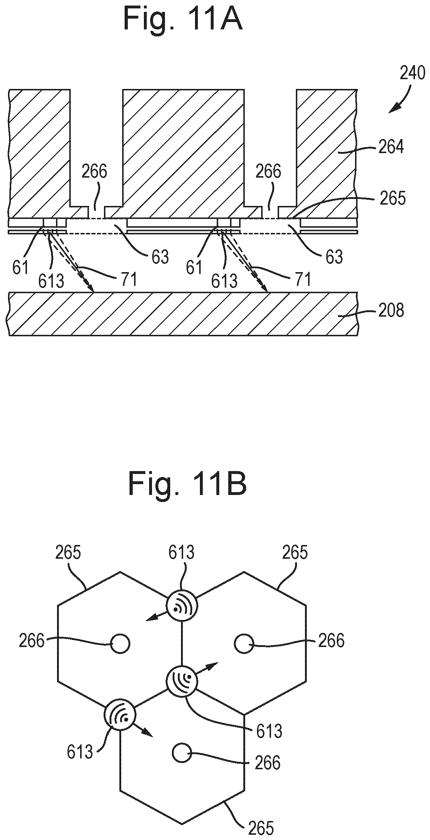

Figure 11A depicts a cross-sectional view through an optical beam element 60 comprising optical radiation sources 61 configured to generate and emit optical radiation towards the sample location. The arrangement of Figure 11A is similar to that of Figure 7 and 9A, wherein the optical beam element 60 is disposed in contact with a downbeam side of the detector substrate 264. In the arrangement of Figure 11A, it is depicted that there is one optical radiation source 61 corresponding to each first beam aperture 63. However, in alternative arrangements, there may be more than one optical radiation source 61, 62 corresponding to each first beam aperture 63. The difference between the arrangement of Figure 7 and that of Figure 11A is that, in the arrangement of Figure 11A the optical radiation sources 61 are each provided with an optical radiation manipulating structure. The optical manipulating structure in the arrangement of Figure 11A comprises a metalens structure 613. A metalens structure 613 such as this may be configured to direct and/or focus the optical radiation, generated and emitted by the respective optical radiation source 61, towards the sample location. This arrangement has the advantage that the optical radiation may be used efficiently, where needed, by appropriately configured directing and focusing the optical radiation beams 71.

Figure 11B shows a close up (i.e., zoomed in) view of some example detector elements 265 on the downbeam side of the detector array 240. Figure 11B also shows the position of the corresponding second beam apertures 266 and the corresponding optical radiation sources 61 with the metalens structure 613 provided thereon. Arrows are used in Figure 11B to show the direction in which each metalens 613 directs the optical radiation generated by the corresponding optical radiation source 61.

As shown in Figures 11A and 11B, each metalens structure 613 is configured to direct and focus the optical radiation beam 71, generated and emitted by the respective optical radiation source 61, towards the sample location. In particular, the metalens structures 613 are preferably configured to direct and focus the beam over the regions of interest, at the sample location corresponding to the respective charged particle beam spot. The metalens structure 613 is optionally formed on an optical manipulating layer of the optical beam element 60, which is downbeam of a layer housing the optical radiation source 61.

The optical manipulating structure optionally comprises a combination of structures, for example a combination or micro-lenses with diffraction elements may be used to focus and/or direct the optical radiation beam 71.

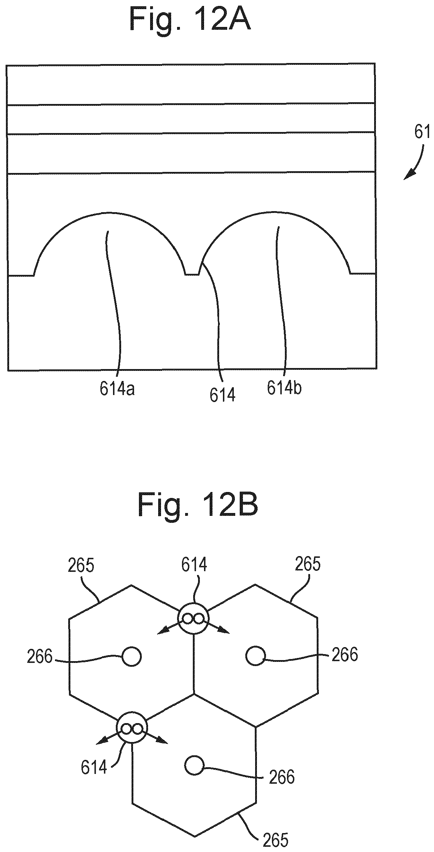

Figure 12A depicts a cross-sectional view through an example of an optical radiation source 61 provided with an optical radiation manipulating structure. The optical manipulating structure in the arrangement of Figure 12A comprises an optical beam-shaping structure 614 comprising a plurality of optical beam-shaping features 614a-b. In the arrangement of Figure 12A, each of the optical beam-shaping features 6114a-b is configured to direct the optical radiation generated and emitted by a respective optical radiation source 61 in a different direction. An optical beam-shaping structure 614 such as this may be configured to direct and/or focus the optical radiation, generated and emitted by the respective optical radiation source 61, towards a plurality of sample locations. This arrangement has the advantage that the optical radiation may be used efficiently, where needed, by appropriately configured directing and focusing the optical radiation beams 71. Furthermore, optical radiation beams 71 from different optical radiation sources 61 may converge at the same charged particle beam spot. As the optical radiation beams 71 from different optical radiation sources 61 may converge from different directions, this may provide more even illumination of the sample location corresponding a given charged particle beam spot.

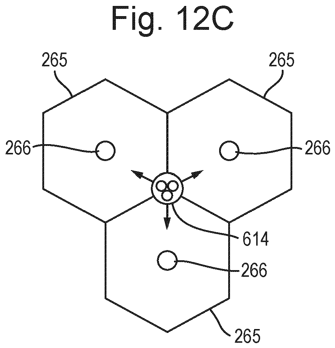

Figure 12B and Figure 12C each shows close up (i.e., zoomed in) view of different example detector elements 265 on the downbeam side of the detector array 240. Figures 12B and 12C also show the position of the corresponding second beam apertures 266 and the corresponding optical radiation sources 61 with the optical beam-shaping structure 614 provided thereon. The optical beam-shaping structures 614 of Figure 12A-C are configured to direct the optical radiation generated and emitted by a respective optical radiation source in a plurality of different directions. Arrows are used in Figure 12B and 12C to show the directions in which each optical beam-shaping feature 614 directs the optical radiation generated by the corresponding optical radiation source 61. The optical beam-shaping structures 614 can therefore be used to receive as an input, the optical radiation generated by the optical radiation source 61 and to provide a plurality of optical radiation beams in different directions based on the input optical radiation generated by the optical radiation source 61. The optical beam-shaping structures can also advantageously be configured to optimise the directionality and focus of the plurality of optical radiation beams.

In the arrangement of Figure 12B, each optical beam-shaping structure 614 comprises two optical beam-shaping features 614a-b, as shown in Figure 12A. Each of the optical beam-shaping structures 614 is configured to direct optical radiation in two different directions, towards the positions corresponding to charged particle beam spots associated with the charged particle beams 211, 212, 213. The charged particle beams 211, 212, 213, being configured to pass through respective, second beam apertures 266. Due to the above-described advantageous re-direction of the optical radiation by the beam-shaping structures 614, only two optical radiation sources with optical beam-shaping structures 614 are required for three charged particle beam spots associated with the three charged particle beams 211, 212, 213. That is, as a result of using optical beam-shaping structures which provide a plurality of optical beams in different directions based on optical radiation from the optical radiation source, fewer optical sources are required for a given number of charged particle beams (for e.g., the number of optical sources being less than the number of charged particle beams on the sample). In the arrangement of Figure 12C, each optical beam-shaping structure 614 is configured to direct the optical radiation in three different directions, towards the positions corresponding to charged particle beam spots of associated with three different charged particle beams 211, 212, 213. The three different charged particle beams 211, 212, 213, being configured to pass through three different, respective, second beam apertures 266. The optical beam-shaping structures 614 of Figure 12C may each comprise three optical beam-shaping features, each feature being configured to direct the optical radiation in a different direction. Again, as a result of using optical beam-shaping structures which provide a plurality of optical beams in different directions based on optical radiation from the optical radiation source, fewer optical sources are required for a given number of charged particle beams (for e.g., the number of optical sources being less than the number of charged particle beams on the sample). Optionally, each optical beam-shaping feature 614a-b may be configured to operate on optical radiation of a different wavelength.

The optical beam-shaping feature 614 may, for example, be an etched optical beam-shaping structure. For example, the optical beam-shaping feature 614 may be etched into a layer comprised within (as shown for example in Figure 12A), in contact with, or adjacent (downbeam) to the corresponding optical radiation source 61.

The optical radiation source 61 and optical beam-shaping features 614 of Figure 12A-C may be employed in an arrangement similar to that of Figure 7, 9A, 10A and 11A, wherein the optical beam element 60 is disposed in contact with a downbeam side of the detector substrate 264. In these arrangements, it is depicted that there is one optical radiation source 61 corresponding to each first beam aperture 63. However, in alternative arrangements, there may be more than one optical radiation source 61, 62 corresponding to each first beam aperture 63.

The optical radiation manipulating structures 611, 612, 613, 614 described above with respect to Figures 9 to 12 may optionally comprise or consist of a transparent conducting material. Alternatively, a coating may be disposed on the one or more optical radiation sources 61, 62, wherein the coating is formed of a transparent conducting material. The coating may mitigate against unwanted charging effects at the optical radiation manipulating structures 611, 612, 613, 614. The transparent conducting material preferably comprises a transparent conductive oxide (TCO). The transparent conductive oxide (TCO) may, for example, comprise indium tin oxide or aluminium-doped zinc oxide.

In the arrangements shown in Figures 9 to 12, the optical radiation sources 61 (and corresponding optical manipulating structures 611-614) are each disposed in a border area between the respective detector element 265 and an adjacent detector element 265. In this way, the optical radiation sources 61 may be disposed on (a downbeam side of) the detector elements 265 while reducing an influence on the detection function of each detector element 265 (compared to an alternative arrangement where the optical radiation source 61 is provided more centrally on the corresponding detector element 265).

The arrangement of Figure 13A is the same as that of Figure 7, except that in Figure 13A the optical radiation sources 61 are each disposed on a respective detector element 265. In particular, in the arrangement of Figure 13A and 13B (which shows a downbeam side of example detector elements 265), the optical radiation sources 61 are each disposed at a more central (i.e., radially inward) location on the respective detector element 265 than the border area of the detector element 265. In other words, in the arrangement of Figure 13A and 13B, the optical radiation sources 61 are each disposed at a more central (i.e., radially inward) location on the respective detector element 265 than the position of the optical radiation sources 61 in the arrangements of Figures 9 to 12 as described above. The arrangement of Figure 13A and 13B has the benefit that the optical radiation sources 61 are each disposed adjacent a respective second beam aperture 266. In other words, the optical radiation sources 61 may be substantially at (but not covering) or near the second beam aperture 266. In this way, the sample location corresponding to the charge particle beam spot associated with said second beam aperture 266 may be more fully and directly illuminated by optical radiation from the respective optical radiation source 61.

The arrangement of Figure 13 has the advantage of the optical radiation sources 61 being favourably located near to or at the second beam aperture 266 in order to more directly emit optical radiation to the sample location which is desired to be illuminated, directly downbeam of the second beam aperture 266.

In the arrangement of Figure 14, the detector 240 comprises a detector substrate 264, the detector elements 265 are disposed on a downbeam surface of the detector substrate 264. The detector elements 265 comprise a transparent conductive material layer 265a. Each optical radiation source 61 is disposed between the detector substrate 264 and the transparent conductive material layer 265a. In this way, the optical radiation sources 61 may be disposed at preferred positions for illumination of areas of interest on the sample 208, with less or no impact on the detector function of the detector elements 265. In particular, the transparent conductive material layer 265a is transparent such that the optical radiation generated and emitted by the optical radiation sources 61 may pass readily through transparent conductive material layer 265a. Thus, the transparent conductive material layer 265a being between the optical radiation sources 61 and the sample 208 does not significantly compromise illumination of the sample 208 with the optical radiation. Similarly, because the detector elements 265 comprise the transparent conductive material layer 265a, the detection function may be performed by the transparent conductive material layer 265a without there being any components (e.g., optical radiation sources 61) downbeam of the by the transparent conductive material layer 265a to obstruct a path of charged particles emitted from the sample 208 towards the by the transparent conductive material layer 265a. The detector elements 265 are therefore able to function with a "clear view" of the sample 208.

As shown in Figure 14A and 14B, a plurality of optical radiation sources 61, 62 may be disposed between the detector substrate 264 and the transparent conductive material layer 265a of the respective detector element 265. In other words, because with this arrangements there is a reduced impact of the presence of the optical radiation sources 61, 62 on the function of the corresponding detector element 265, there is the option to provide a greater number of optical radiation sources 61, 62 per detector element 265 and/or to place the optical radiation sources 61, 62 at the preferred position (e.g., at/near the second beam aperture 266) to improve efficiency and effectiveness of providing optical radiation to the sample locations at which the charged particle beam spots are formed.

The optical radiation manipulating structures 611, 612, 613, 614 described above with respect to Figures 9 to 12 are depicted as being provided to manipulate optical radiation from the optical radiation sources 61 an arrangement similar to that of Figure 7, wherein the optical beam element 60 is disposed in contact with a downbeam side of the detector substrate 264. In alternative arrangements, one or more the optical radiation manipulating structures 611, 612, 613, 614 (e.g., as described above with respect to Figures 9 to 12) may be provided to manipulate optical radiation from the optical radiation sources 61 in an arrangement (similar to that of Figure 8) wherein the aperture element, such as the detector 240, is disposed between the optical beam member 60 and the sample 208.

In each of these arrangements, the optical beam member 60 is upbeam of the detector 240. The optical radiation sources 61, 62 may be disposed in a region orthogonal to the border area, in a plane of the detector elements 265, between the respective detector element 265 and an adjacent detector element 265. In other words, if the detector elements 265 extend in an array in the X-Y plane, the optical radiation sources 61, 62 may be disposed at a position which is directly in a Z-direction (i.e., a generally upbeam direction) from the border area between the respective detector element 265 and the adjacent detector element 265. In other words, viewed from above, the optical radiation sources 61, 62 may be disposed at a lateral position (i.e., a position in the X-Y plane) to overlap with the border area. Alternatively, for example as shown in Figure 15B, the the optical radiation sources 61, 62 may be disposed in a region orthogonal to an area, in a plane of the detector elements 265, corresponding to the respective detector element 265. In other words, the detector elements 265 extend in the array in the X-Y plane, the optical radiation sources 61, 62 may be disposed at a position which is directly in a Z-direction (i.e., a generally upbeam direction) from the respective detector element 265. In other words, viewed from above, the optical radiation sources 61, 62 may be disposed at a lateral position (i.e., a position in the X-Y plane) to overlap with the respective detector element 265.

For example, Figure 15A and 15B depicts such an arrangement, similar to that of Figure 8, wherein the aperture element, such as the detector 240, is disposed between the optical beam member 60 and the sample 208. As shown in Figure 15A, the optical radiation sources 61, 62 are supported by a substrate of the optical beam member 60. The optical beam member 60 may be considered to be a photonic element, such as a photonic integrated circuit (PIC).

In order for the optical radiation to be directed from the optical beam member 60 to the sample location, the optical radiation generated and emitted by the optical radiation sources 61, 62 may be appropriately directed and/or focused. For example, the optical radiation sources 61, 62 may be provided with one or more of the manipulating structures 611, 612, 613, 614, as described above with respect to Figures 9 to 12 to appropriately direct and/or focus the optical radiation through the second beam aperture 266 defined in the detector substrate 264 and to the sample 208.

As described above, with the optical beam element 60 being a separate element/component upbeam of the detector 240 (e.g., not disposed on or integrated with the detector 240 or disposed downbeam thereof), the placement of the optical radiation sources 61, 62 does not influence the functioning of the detector elements 265. Hence, as shown in Figure 15B the optical radiation sources 61, 62 may optionally be disposed at a lateral position (i.e., a position in the X-Y plane) to overlap with the respective detector element 265. Furthermore, more than one optical radiation source 61, 62 may be provided to correspond to each respective detector element 265.

In arrangements having more than one optical radiation source 61, 62 to correspond to each respective detector element 265, the optical radiation sources 61, 62 may be configured to emit optical radiation of the same wavelength. These optical radiation sources 61, 62 may be placed, preferably symmetrically with respect to the respective detector element 265, to create a more homogeneous intensity distribution of the optical radiation in the areas of interest on the sample 208. Alternatively, or additionally, optical radiation sources 61, 62 configured to emit optical radiation of multiple different wavelengths. For example, one radiation source 61 may configured to emit optical radiation of a first wavelength (e.g., corresponding to light of a first color), and the other radiation source 62 associated with the same respective detector element 265 may be configured to emit optical radiation of a second wavelength different to the first wavelength (e.g., corresponding to light of a second color).

Figure 16A and 16B depicts an arrangement, similar to that of Figure 15A and 15B as described above, wherein an aperture element, such as the detector 240, is disposed between the optical beam member 60 and the sample 208. The difference is that, whereas the arrangement of Figure 15 comprised a plurality of optical radiation sources 61, 62 corresponding to each first beam aperture 63, in the arrangement of Figure 16A to 16D there is a, single, ring optical radiation source 61 corresponding to each first beam aperture 63, and that ring optical radiation source 61 has an annular ring shape surrounding the first beam aperture 63. The ring optical radiation source 61 may, for example, be a light emitting diode (LED) or photonic crystal surface-emitting laser (PCSEL).

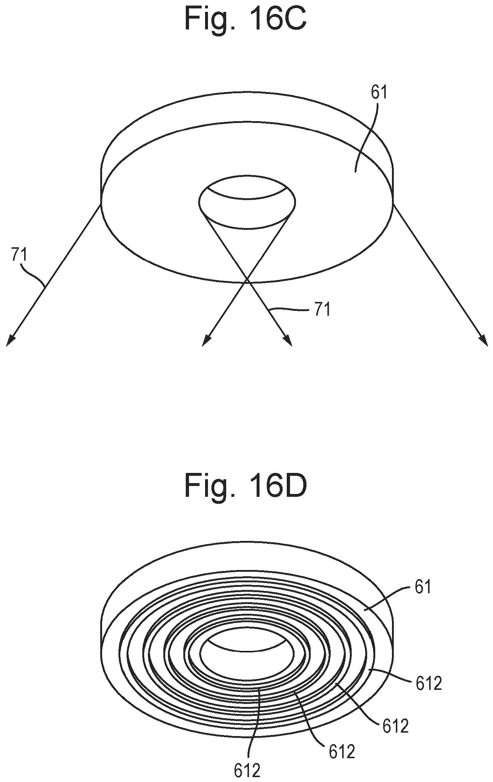

Figures 16C and 16D provide views of possible configurations of the ring optical radiation source 61 having an annular ring shape. Figure 16C shows that optical radiation may be emitted from the annular ring shape such that an overlap of optical radiation may be provided in a central region following the axis of the first beam aperture 63. In this way, the intensity of optical radiation at the sample location may, beneficially, inherently be greatest at a position likely to coincide with the respective charged particle beam spot. The ring optical radiation sources 61 may be provided with one or more of the optical radiation manipulating structures 611, 612, 613, 614, as described above with respect to Figures 9 to 12, to appropriately direct and/or focus the optical radiation. For example, Figure 16D shows a diffractive structure 612 provided on a downbeam side of the ring optical radiation source 61. The diffractive structure 612 of Figure 16D has a concentric arrangement. In another example, a metalens and/or Fresnel lens may be provided as an optical radiation manipulating structure to manipulate the optical radiation from the ring optical radiation sources 61.

In an alternative arrangement, instead of the plurality of ring optical radiation sources, larger optical radiation sources 61 could over a larger area. For example, instead of having one single ring optical radiation source 61 per first beam aperture 63, as shown in Figure 16A and 16B, a larger optical radiation source 61 (not shown) may be provided to correspond to a plurality of first beam apertures 63. For example, a large optical radiation source 61 may be provided with a plurality of holes to accommodate a plurality of the first beam apertures 63. The large optical radiation source 61 may, for example be an LED or PCSEL. The holes may, for example, be etched or drilled in the large optical radiation source 61to correspond to the first beam apertures 63. The use of a larger optical radiation source 61 to provide optical radiation corresponding to a plurality of first beam apertures 63, rather than providing each first beam aperture 63 with one or more smaller optical radiation sources 61, 62 may significantly simplify the power circuitry and thus the fabrication of the optical beam element 60.

In arrangements, such as shown in Figures 8, 14 and 15, wherein the one or more optical radiation sources associated with each first beam aperture 63 and/or second beam aperture 266 comprises a plurality of optical radiation sources 61, 62, the optical beam member 60 may optionally be configured such that the plurality of optical radiation sources 61, 62 emit optical beams 71, 72 that are coherent with each other. In some arrangements the optical beams 71, 72 emitted by the optical radiation sources 61, 62 are symmetric with respect to the charged particle-optical axis and are in-phase with each other such that the optical beams 71, 72 constructively interfere with each other and the intensity of the resultant optical beam spot on the sample is preferably maximized at the sample location where the charged particle beam spot impinges the sample. In other arrangements, the optical radiation sources 61, 62 may alternatively or additionally be arranged adjacent the first beam aperture 63 such that the intensity of the resultant optical beam spot enables voltage contrast defect detection in a scan region of the charged particle beam spot on the sample location.

Features in electron-optical plates may be manufactured using techniques from microelectromechanical systems (MEMS) (i.e. using MEMS manufacturing techniques). MEMS are miniaturized mechanical and electromechanical elements that are made using microfabrication techniques. Merely as an example, a collimator array may be formed using MEMS manufacturing techniques so as to be spatially compact. As another example, a scan deflector array may be formed using MEMS manufacturing techniques.

In an embodiment, the controller 150 is configured to control the electron-optical device 230. The controller 150 may be configured to control potentials applied to electrodes of lenses of the electron-optical device 230.

In an embodiment the controller 150 is configured to control the actuatable stage 209 to move the sample 208 during inspection of the sample 208. The controller 150 may enable the actuatable stage 209 to move the sample 208 in a direction, for example continuously, such as at a constant speed, at least during sample inspection, which may be referred to as a type of scanning. The speed of the actuatable stage 209 may be referred to as the moving rate. The controller 150 may control movement of the actuatable stage 209 so as to change the speed of movement of the sample 208 relative to the beam paths dependent on one or more parameters. The controller 150 may control deflection of scan deflectors so that the beam paths move relative to the actuatable stage 209 and thus over the surface of the sample 208. The controller 150 may change a beam deflection of a scan deflector and thus the scanning of the primary beams 211, 212, 213 over the sample 208 dependent on one or more parameters. For example, the controller 150 may control a scan deflector and/or the speed of the actuatable stage 209 and/or the direction of movement of the actuatable stage 209 depending on characteristics of the assessment process. The disclosure in EP4086933 A1 of a combined stepping and scanning strategy of the stage and scanning deflectors is hereby incorporated by reference. The moving rate may at different times comprise a stepping frequency and/or a stage scanning rate.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Embodiments include the following numbered clauses:
1. An optical beam member for a charged particle-optical device configured to direct a charged particle beam towards a sample location, the optical beam member comprising:
   a first beam aperture for passage of the charged particle beam;
   one or more optical radiation sources arranged adjacent the first beam aperture, the optical radiation sources being configured to generate and emit optical radiation beams towards the sample location such that an optical beam spot on the sample associated with the one or more optical radiation sources is substantially coincident with a charged particle beam spot on the sample, the said charged particle beam spot being associated with the charged particle beam.
2. The optical beam member of clause 1, wherein the optical beam member comprises a substrate which defines the first beam aperture, and wherein the optical radiation sources are configured to be integrated optical radiation sources, wherein the integrated optical radiation sources are integrated in the substrate.
3. The optical beam member of clause 1 or 2, wherein one or more optical radiation sources are configured to generate and emit light of a wavelength from 400 nm to 800 nm.
4. The optical beam member of any preceding clause, wherein the one or more optical radiation sources are micro optical radiation sources.
5. The optical beam member of clause 4, wherein the micro optical radiation sources each have a height and/or width of from 1 micrometer to 50 micrometers.
6. The optical beam member of any preceding clause, wherein the one or more optical radiation sources are selected from a group comprising: a light emitting diode, a vertical-cavity surface-emitting laser and/or a photonic crystal surface-emitting laser.
7. The optical beam member of any preceding clause, wherein the power provided to each of the optical radiation sources is within 30 % of a threshold power level.
8. The optical beam member of any preceding clause being further configured for a charged particle-optical device configured to direct a plurality of charged particle beams along respective charged particle-optical axes towards the sample location, wherein the optical beam member comprises a plurality of the first beam apertures for passage of respective charged particle beams towards the sample location.
9. The optical beam member of clause 8, wherein the plurality of first beam apertures comprises a subset of the first beam apertures, and wherein the optical radiation sources comprise one or more optical radiation sources adjacent each beam aperture of the subset of the first beam apertures, the optical radiation sources being configured to generate and emit optical radiation beams towards the sample location such that an optical beam spot on the sample associated with the one or more optical radiation sources is substantially coincident with a respective charged particle beam spot on the sample.
10. The optical beam member of clause 8, wherein the optical radiation sources comprise one or more optical radiation sources adjacent each of the plurality of first beam apertures first beam aperture, the optical radiation sources being configured to generate and emit optical radiation beams towards the sample location such that an optical beam spot on the sample associated with the one or more optical radiation sources is substantially coincident with a respective charged particle beam spot on the sample.
11. The optical beam member of any preceding clause, wherein each of the one or more optical radiation sources comprises optical radiation manipulating structures configured to direct and/or focus the optical radiation towards the sample location.
12. The optical beam member of clause 11, wherein the optical radiation manipulating structures comprise diffractive structures, wherein each diffractive structure is configured to direct the optical radiation, generated and emitted by a respective optical radiation source, towards the sample location.
13. The optical beam member of clause 11 or 12, wherein the optical radiation manipulating structures comprise micro-lensing structures, wherein each micro-lensing structure is configured to direct and/or focus the optical radiation, generated and emitted by a respective optical radiation source, towards the sample location.
14. The optical beam member of any of clause 13, wherein the micro-lensing structures comprise a focusing diffractive structures.
15. The optical beam member of clause 13 or 14, wherein the micro-lensing structures comprise metalens structures.
16. The optical beam member of any of clauses 11 to 15, wherein the optical radiation manipulating structures comprise optical beam-shaping structures, wherein each optical beam-shaping structure is configured to direct and/or focus the optical radiation, generated and emitted by a respective optical radiation source, towards the sample location.
17. The optical beam member of clause 16, wherein each optical beam-shaping structure comprise a plurality of optical beam-shaping features, wherein each of the optical beam-shaping features is configured to direct the optical radiation generated and emitted by a respective optical radiation source in a different direction.
18. The optical beam member of clause 16 or 17, wherein the optical beam-shaping structure is an etched optical beam-shaping structure.
19. The optical beam member of any one of clauses 11 to 18, wherein the optical radiation manipulating structures comprise or consist of a transparent conducting material.
20. The optical beam member of any preceding clause, wherein a coating is disposed on the one or more optical radiation sources, wherein the coating is formed of a transparent conducting material.
21. The optical beam member of clause 19 or 20, wherein the transparent conducting material comprises a transparent conductive oxide (TCO).
22. The optical beam member of clause 21, wherein the transparent conductive oxide comprises indium tin oxide or aluminium-doped zinc oxide.
23. An optical beam member for a charged particle-optical device configured to direct a charged particle beam towards a sample location, the optical beam member comprising:
   a first beam aperture for passage of the charged particle beam;
   one or more optical radiation sources arranged adjacent the first beam aperture, the optical radiation sources being configured to generate and emit optical radiation beams towards the sample location.
24. An assembly for a charged particle-optical device configured to direct a charged particle beam towards a sample location, the assembly comprising:
   an aperture element, wherein a second beam aperture is defined in the aperture element for passage of the charged particle beam towards the sample location; and
   the optical beam member of any of clauses 1 to 23, wherein the optical beam member is between the aperture element and the sample location.
25. An assembly for a charged particle-optical device configured to direct a plurality of charged particle beams towards the sample location, the assembly comprising:
   an aperture element, wherein a plurality of second beam apertures are defined in the aperture element for passage of the respective charged particle beams towards the sample location; and
   an optical beam member according to any of clauses 8 to 22, when dependent on clause 8, wherein the optical beam member is between the aperture element and the sample location.
26. The assembly of clause 24 or 25, wherein the aperture element comprises a detector array facing the sample location and configured to detect emitted charged particles from the sample location in response to the charged particle beam spot on the sample location, wherein the second beam aperture is defined in the detector array.
27. The assembly of clause 26, wherein the detector array comprises a plurality of detector elements, and wherein in a plane of the detector element, a lateral dimension of the second beam aperture is less than half a lateral dimension of the detector element.
28. The assembly of clause 26 or 27, wherein the optical beam member is integrated with, or disposed directly in contact with, the detector array.
29. An assembly for a charged particle-optical device configured to direct a charged particle beam towards a sample location, the assembly comprising:
   the optical beam member of any of clauses 1 to 23; and
   an aperture element between the optical beam member and the sample location, wherein a second beam aperture is defined in the aperture element for passage of the charged particle beam towards the sample location.
30. The assembly of clause 29, wherein the one or more optical radiation sources are configured to emit the respective optical radiation beams such that the respective optical radiation beams pass through the second beam aperture towards the sample location, and optionally wherein the assembly comprises a plurality of optical radiation sources associated with the first beam aperture, wherein:
   (i) the plurality of optical radiation sources are coherent with each other and configured such that the plurality of optical radiation beams overlap resulting in constructive interference at or near the second beam aperture to form a corresponding optical beam spot on the sample location, or
   (ii) the respective of optical radiation beams overlap or are superimposed, at or near the second beam aperture to form a corresponding optical beam spot on the sample location.
31. An assembly for a charged particle-optical device configured to direct a plurality of charged particle beams towards the sample location, wherein the assembly comprises an optical beam member according to any of clauses 8 to 22, when dependent on clause 8, and
   an aperture element between the optical beam member and the sample location, wherein a plurality of second beam apertures are defined in the aperture element for passage of the respective charged particle beams towards the sample location.
32. The assembly of clause 31, wherein for each second beam aperture, the optical beam member is further configured to emit the respective optical radiation beams, from the optical radiation sources, to pass through the respective second beam apertures towards the sample location.
33. The assembly of clause 32, wherein the one or more optical radiation sources associated with each second beam aperture comprises a plurality of optical radiation sources, wherein the plurality of optical radiation sources is configured to emit a respective plurality of optical radiation beams to pass through the respective second beam aperture,
   wherein the plurality of optical radiation sources are coherent with each other and configured such that the plurality of optical radiation beams overlap resulting in constructive interference.
34. The assembly of clause 31 or 32, wherein the one or more optical radiation sources associated with each second beam aperture are configured to emit the respective optical radiation beams, substantially at or near the respective second beam aperture.
35. The assembly of clause 34, wherein the one or more optical radiation sources associated with each second beam aperture comprises a plurality of optical radiation sources, wherein the plurality of optical radiation sources is configured to emit a respective plurality of optical radiation beams to pass through the respective second beam aperture,
   wherein the plurality of optical radiation beams overlap at or near the second beam aperture to form a corresponding optical beam spot on the sample location.
36. The assembly of any of clauses 24 to 35, wherein the aperture element comprises a detector array facing the sample location and configured to detect charged particles from the sample location, wherein the second beam apertures are defined in the detector array.
37. The assembly of clause 36, wherein the detector array comprises a plurality of detector elements, each surrounding one of the second beam apertures.
38. The assembly of clause 37, wherein in a plane of the detector elements, a lateral dimension of each second beam aperture is less than half a lateral dimension of the respective detector element.
39. The assembly of clause 37 or 38, wherein the one or more optical radiation sources are each disposed on a respective detector element.
40. The assembly of clause 39, wherein the one or more optical radiation sources are each disposed adjacent a respective second beam aperture.
41. The assembly of clause 39 or 40, wherein the one or more optical radiation sources are each disposed closer to the respective second beam aperture than a border area between the respective detector element and an adjacent detector element of the detector element.
42. The assembly of any one of clauses 37 to 41, wherein the aperture element comprises a detector substrate, the detector elements are disposed on a downbeam surface of the detector substrate, the detector elements comprise a transparent conductive material layer, and each optical radiation source is disposed between the detector substrate and the transparent conductive material layer.
43. The assembly of clause 42, wherein a plurality of optical radiation sources are disposed between the detector substrate and the transparent conductive material layer of the respective detector element.
44. The assembly of any one of clauses 37 to 43, wherein the one or more optical radiation sources are each disposed in a region orthogonal to an area, in a plane of the detector elements, corresponding to the respective detector element.
45. The assembly of any one of clauses 37 to 43, wherein the one or more optical radiation sources are each disposed in a region orthogonal to a border area, in a plane of the detector elements, between the respective detector element and an adjacent detector element.
46. A charged particle-optical device configured to direct a charged particle beam towards a sample location, the charged particle-optical device comprising:
   the assembly of any of clauses 24, 29, 30 or clauses 36 to 45 when dependent on any of clauses 24, 29, or 30.
47. A charged particle-optical device configured to direct a plurality of charged particle beams towards a sample location, the charged particle-optical device comprising:
   the assembly of any of clauses 26, 27, 28, or 31 to 45 when dependent on any of clauses 26, 27, 28, or 31.
48. The charged particle-optical device of clause 38 or 39, comprising:
   an objective lens configured to focus the charged particle beam onto the sample location, wherein the optical beam member is between the objective lens and the sample location.
49. A charged particle-optical apparatus comprising:
   the charged particle-optical device of any of clauses 38 to 40; and
   an actuatable stage configured to support a sample at the sample location.
50. A method for directing optical beams towards a sample, the method comprising:
   generating and emitting, from one or more optical radiation sources of an optical beam member of a charged particle-optical device configured to direct a charged particle beam towards a sample, respective optical beams towards the sample such that an optical beam spot on the sample associated with the one or more optical radiation sources is substantially coincident with a charged particle beam spot on the sample,
   wherein a first beam aperture is defined in an optical beam member for passage of the charged particle beam towards the sample, and wherein the one or more optical radiation sources are arranged adjacent the first beam aperture, the said charged particle beam spot being associated with the charged particle beam.
51. The method of clause 50, comprising:
   directing, using the charged particle-optical device, a charged particle beam towards a sample, such that the charged particle beam passes through the first beam aperture.
52. The method of clause 50 or 51, wherein the charged particle-optical device is configured to direct a plurality of charged particle beams along respective charged particle-optical axes towards the sample location, wherein the optical beam member comprises a plurality of the first beam apertures for passage of respective charged particle beams towards the sample location,
   wherein for each first beam aperture, the optical beam member comprises one or more optical radiation sources arranged adjacent the respective first beam aperture and configured to emit the respective optical beams that form the combined optical beam towards the sample.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

### List of reference numerals:

60 optical beam member
61, 62 optical radiation sources
63 first beam aperture
71, 72 optical radiation beams
100 assessment apparatus
110 vacuum chamber (main chamber)
120 load lock chamber
124 gun aperture
125 beam limit aperture
130 EFEM
130a first loading port
130b second loading port
132a pole piece
132b control electrode
132c deflector
132d exciting coil
135 column aperture
140 electron-optical apparatus (electron beam apparatus, electron apparatus)
148 first multipole lens
150 controller
158 second multipole lens
201 source
202 source beam
204 electron-optical axis
207 sample holder
208 sample
209 actuatable stage
211, 212, 213 primary beams (sub-beams, beamlets)
220 source converter (micro-optical array)
223 pre-bending deflector array
224 aberration reduction array
230 electron-optical device (electron-optical column)
231 condenser lens array
240 detector array
241 objective lens array
242 beam shaper array
243 objective lens
250 control lens array
252 beam limiting aperture array
260 scan deflector array
261 plate
264 detector substrate
265 detector elements
266 beam apertures
267 logic layer
268 wiring layer
269 through-substrate vias
270 macro collimator
271 collimator array
272 Coulomb aperture array
273 intermediate focus plane
274 macro condenser lens
275 macro scan deflector
281-283 probe spots
291 photon converter array
292 fluorescent strip
293 openings
295 deflector array
296 magnetic deflector
297 electrostatic deflector
298 optical fiber
299 electron-optical device array
611 micro-lensing structure
612 diffractive structure
613 metalens structure
614 optical beam-shaping structures

## Claims

**1.** An optical beam member for a charged particle-optical device configured to direct a charged particle beam towards a sample location, the optical beam member comprising:
a first beam aperture for passage of the charged particle beam;
one or more optical radiation sources arranged adjacent the first beam aperture, the optical radiation sources being configured to generate and emit optical radiation beams towards the sample location such that an optical beam spot on the sample associated with the one or more optical radiation sources is substantially coincident with a charged particle beam spot on the sample, the said charged particle beam spot being associated with the charged particle beam.

**2.** The optical beam member of claim 1, wherein the optical beam member comprises a substrate which defines the first beam aperture, and wherein the optical radiation sources are configured to be integrated optical radiation sources, wherein the integrated optical radiation sources are integrated in the substrate.

**3.** The optical beam member of any preceding claim, wherein the one or more optical radiation sources are micro-optical radiation sources.

**4.** The optical beam member of any preceding claim being further configured for a charged particle-optical device configured to direct a plurality of charged particle beams along respective charged particle-optical axes towards the sample location, wherein the optical beam member comprises a plurality of the first beam apertures for passage of respective charged particle beams towards the sample location.

**5.** The optical beam member of claim 4, wherein the one or more optical radiation sources are arranged adjacent each of the plurality of first beam apertures, the one or more optical radiation sources being configured to generate and emit optical radiation beams towards the sample location such that an optical beam spot on the sample associated with the one or more optical radiation sources is substantially coincident with a respective charged particle beam spot on the sample.

**7.** The optical beam member of any preceding claim, wherein each of, or a subset of the one or more optical radiation sources comprises optical radiation manipulating structures configured to direct and/or focus the optical radiation towards the sample location.

**8.** The optical beam member of claim 7, wherein the optical radiation manipulating structures comprise diffractive structures, wherein each diffractive structure is configured to direct the optical radiation, generated and emitted by a respective optical radiation source, towards the sample location.

**9.** The optical beam member of claim 7 or 8, wherein the optical radiation manipulating structures comprise micro-lensing structures, wherein each micro-lensing structure is configured to direct and/or focus the optical radiation, generated and emitted by a respective optical radiation source, towards the sample location.

**10.** The optical beam member of any of claims 7 to 9, wherein the optical radiation manipulating structures comprise optical beam-shaping structures, wherein each optical beam-shaping structure is configured to direct and/or focus the optical radiation, generated and emitted by a respective optical radiation source, towards the sample location.

**11.** An assembly for a charged particle-optical device configured to direct a plurality of charged particle beams towards the sample location, the assembly comprising:
an aperture element, wherein a plurality of second beam apertures are defined in the aperture element for passage of the respective charged particle beams towards the sample location; and
an optical beam member according to any of claims 4 to 10, when dependent on claim 4, wherein the optical beam member is between the aperture element and the sample location.

**12.** An assembly for a charged particle-optical device configured to direct a plurality of charged particle beams towards the sample location, wherein the assembly comprises:
an optical beam member according to any of claims 4 to 10, when dependent on claim 4; and
an aperture element between the optical beam member and the sample location, wherein a plurality of second beam apertures are defined in the aperture element for passage of the respective charged particle beams towards the sample location.

**13.** The assembly of claim 12, wherein for each second beam aperture, the optical beam member is further configured to emit the respective optical radiation beams, from the optical radiation sources, to pass through the respective second beam apertures towards the sample location.

**14.** The assembly of claim 13, wherein the one or more optical radiation sources associated with each second beam aperture comprises a plurality of optical radiation sources, wherein the plurality of optical radiation sources is configured to:
(i) emit a respective plurality of optical radiation beams to pass through the respective second beam aperture, wherein the plurality of optical radiation sources are coherent with each other and configured such that the plurality of optical radiation beams overlap resulting in constructive interference; and/or
(ii) emit the respective optical radiation beams, substantially at or near the respective second beam aperture.

**15.** A charged particle-optical device configured to direct a plurality of charged particle beams towards a sample location, the charged particle-optical device comprising the assembly of any of claims 11-14.
